(19) **Europäisches Patentamt / European Patent Office / Office européen des brevets**

(11) **EP 2 665 349 B1**

(12) **EUROPEAN PATENT SPECIFICATION**

(45) Date of publication and mention
of the grant of the patent:
**12.04.2017 Bulletin 2017/15**

(51) Int Cl.:
*H05K 7/20* (2006.01)     *G06F 1/20* (2006.01)

(21) Application number: **11864855.9**

(86) International application number:
**PCT/CN2011/080121**

(22) Date of filing: **23.09.2011**

(87) International publication number:
**WO 2012/149768 (08.11.2012 Gazette 2012/45)**

(54) **SUBMERGED COOLING SYSTEM AND METHOD**

UNTERWASSERKÜHLSYSTEM UND VERFAHREN

SYSTÈME ET PROCÉDÉ DE REFROIDISSEMENT SUBMERGÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**20.11.2013 Bulletin 2013/47**

(73) Proprietor: **Huawei Technologies Co., Ltd.
Longgang District
Shenzhen, Guangdong 518129 (CN)**

(72) Inventors:
• **LUO, Zhaoxia
Shenzhen
Guangdong 518129 (CN)**
• **HUANG, Shuliang
Shenzhen
Guangdong 518129 (CN)**

• **KE, Youhe
Shenzhen
Guangdong 518129 (CN)**
• **ZHAI, Liqian
Shenzhen
Guangdong 518129 (CN)**

(74) Representative: **Gill Jennings & Every LLP
The Broadgate Tower
20 Primrose Street
London EC2A 2ES (GB)**

(56) References cited:
WO-A1-2010/058274     CN-A- 1 251 494
CN-A- 101 588 707     US-A- 4 053 942
US-A- 5 373 417       US-A1- 2007 034 360
US-A1- 2010 139 544

EP 2 665 349 B1

## Description

### TECHNICAL FIELD

The present invention relates to the field of information and communications, and in particular, to an immersion cooling system and method.

### BACKGROUND

With rapid development of the information and communications industry, the integration level and heat density of a device become higher and higher. With increasing power consumption of a chip and a higher integration level of a device, a conventional technology that uses air as a medium to dissipate heat for an electronic product is increasingly not enough to meet requirements. The industry starts to seek a higher-density heat dissipation solution, and immersion cooling comes into people's view.

Immersion cooling refers to immersing a heat source in a non-conductive liquid to dissipate heat and control the temperature within a reasonable range. Compared with a conventional air cooling technology, immersion heat dissipation can deal with much higher heat density. Meanwhile, a system solution that adopts immersion heat dissipation is relatively simple, generally involves fewer components, and has higher reliability. However, after heat generated by a heat source immersed in a non-conductive working medium is absorbed by the non-conductive working medium, a temperature of the non-conductive working medium increases and a volume of the non-conductive working medium expands. Therefore, when an immersion heat dissipation solution is adopted, volume expansion of a working medium must be considered to prevent a safety problem caused by damage to a case due to the volume expansion.

To control a pressure rise caused by volume expansion of a non-conductive working medium in an immersion cooling system, most existing immersion cooling solutions in the industry adopt a manner of installing an exhaust valve. In the prior art, a specialized exhaust valve is set to prevent a pressure from rising or even causing a safety problem. A non-conductive working medium is contained in a case made of a solid material. By adopting this exhaust valve solution, a certain space is generally reserved at the time of filling a fluid working medium, that is, the non-conductive working medium occupies only a part of a space enclosed by the case, and the remaining space still contains gas. When a temperature of the non-conductive working medium rises and a volume of the non-conductive working medium expands, the non-conductive working medium starts to extrude the gas; and when a pressure of the gas rises to some extent, an exhaust pressure relief valve installed on a surface of the case starts to work and expels a part of the gas to the outside to reduce a pressure in the case.

An existing exhaust pressure relief valve in the industry generally has a large size and generally needs to be installed at a high position in a system. Therefore, its installation manner is limited to some extent. In addition, for an electronic device part that is not immersed in the non-conductive working medium but exposed in the gas, its heat dissipation capability is greatly affected. Especially for a board-level immersion system applied to a horizontal insertion frame, existence of an air layer seriously deteriorates heat transfer between a non-conductive working medium and a cold source case, thereby deteriorating heat dissipation performance of the entire system.

US 5373417 discloses a liquid cooled circuit package.

Embodiments of the present invention provide an immersion cooling system and method.

An embodiment of the present invention provides an immersion cooling system, wherein: the system comprises an electronic device, a non-conductive working medium, and plural gasbags; the electronic device is immersed in the non-conductive working medium; the non-conductive working medium is configured to dissipate heat for the electronic device, and a volume of the non-conductive working medium expands as a temperature rises; and a surface of the gasbag is elastic, and the gasbag is configured to reduce its volume when the gasbag is compressed by volume expansion of the non-conductive working medium, so as to buffer a pressure rise in the system, wherein the pressure rise is caused by the volume expansion of the non-conductive working medium, wherein: the number of gasbags is determined according to a volume expansion value of the non-conductive working medium and a volume decrease value of each gasbag, and wherein the number of gasbags is determined according to the following formula:

$$\sum_{i>1}^{N} \nabla v_i \geq \nabla V$$

,

wherein $\nabla V$ represents the volume expansion value of the non-conductive working medium, and $\nabla v_i$ represents a volume decrease value of an i$^{th}$ gasbag, wherein i is a natural number that is greater than 1 but less than or equal to N; and N is the number of the gasbags, and N needs to ensure that a sum of volume decrease values of all gasbags is greater than or equal to the volume expansion value of the non-conductive working medium.

An embodiment of the present invention provides an immersion cooling method, wherein the method comprises: dissipating heat for an electronic device by using a non-conductive working medium in a closed container, wherein the electronic device is immersed in the non-conductive working medium, and placing gasbags in the non-conductive working medium; and reducing, by the gasbags, their volume when the gasbags are compressed by volume expansion of the non-conductive working medium, so as to buffer a pressure rise in a system, wherein the volume expansion of the non-conductive working medium is caused by dissipating heat for the electronic device and the pressure rise is caused by the volume expansion of the non-conductive working medium wherein: the placing gasbags in the non-conductive working medium comprises: determining the number of gasbags according to a volume expansion value of the non-conductive working medium and a volume decrease value of each gasbag, and wherein: the determining the number of the gasbags according to a volume expansion value of the non-conductive working medium and a volume decrease value of each gasbag specifically comprises: determining the number of gasbags according to the following formula:

$$\sum_{i>1}^{N} \nabla v_i \geq \nabla V$$

,

wherein $\nabla V$ represents the volume expansion value of the non-conductive working medium, and $\nabla v_i$ represents a volume decrease value of an $i^{th}$ gasbag, wherein i is a natural number that is greater than 1 but less than or equal to N; and N is the number of the gasbags, and N needs to ensure that a sum of volume decrease values of all gasbags is greater than or equal to the volume expansion value of the non-conductive working medium.

With the immersion cooling system and method provided in the embodiments of the present invention, a gasbag is used in place of an exhaust valve, so that installation is more flexible and cooling performance is further improved.

**BRIEF DESCRIPTION OF DRAWINGS**

To describe the technical solutions in the embodiments of the present invention or in the prior art more clearly, the following briefly introduces the accompanying drawings required for describing the embodiments or the prior art. Apparently, the accompanying drawings in the following description merely show some embodiments of the present invention, and persons of ordinary skill in the art may also derive other drawings from these accompanying drawings without creative efforts.

FIG. 1 is a structural diagram of an immersion cooling system according to an embodiment of the present invention;
FIG. 2 is a schematic diagram of a gasbag with only part of movable surfaces according to an embodiment of the present invention; and
FIG. 3 is a flowchart of an immersion cooling method according to an embodiment of the present invention.

**DESCRIPTION OF EMBODIMENTS**

To make the objectives, technical solutions, and advantages of the embodiments of the present invention more comprehensible, the following clearly and completely describes the technical solutions in the embodiments of the present invention with reference to the accompanying drawings in the embodiments of the present invention. Apparently, the embodiments to be described are merely a part rather than all of the embodiments of the present invention. All other embodiments obtained by persons of ordinary skill in the art based on the embodiments of the present invention without creative efforts shall fall within the protection scope of the present invention.

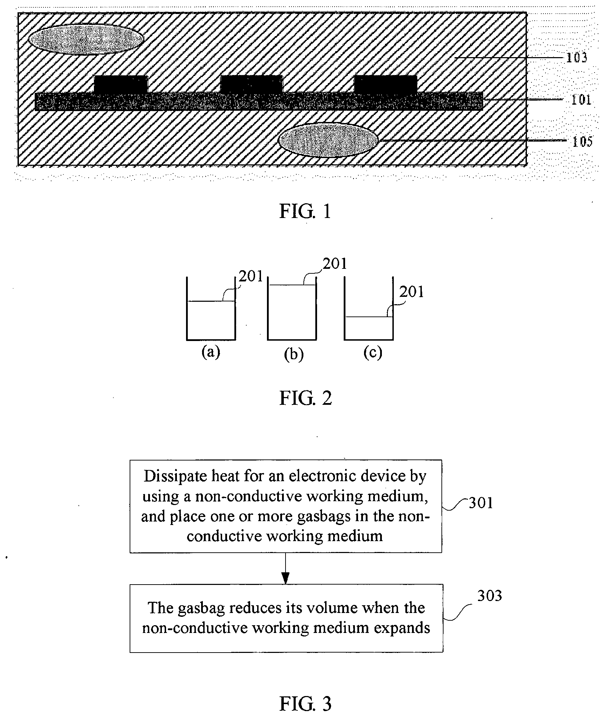

An embodiment of the present invention provides an immersion cooling system. Referring to FIG. 1, FIG. 1 is a structural diagram of an immersion cooling system according to an embodiment of the present invention. The system includes: an electronic device 101, a non-conductive working medium 103, and one or more gasbags 105, where the electronic device is immersed in the non-conductive working medium; the non-conductive working medium is configured to dissipate heat for the electronic device, and a volume of the non-conductive working medium expands as a temperature rises; and a surface of the gasbag is elastic, and the gasbag is configured to reduce its volume when the gasbag is compressed by volume expansion of the non-conductive working medium, so as to buffer a pressure rise in the system, where the pressure rise is caused by the volume expansion of the non-conductive working medium.

The heat source electronic device 101 is immersed in the non-conductive working medium, and the non-conductive working medium 103 fills up the inside of a case. Gasbags of different sizes and different shapes are placed in the non-conductive working medium.

The gasbag 105 is packed with a gas. The gasbag is generally made of a rubber material, and its surface has a certain compression or expansion capability. In a specific implementation instance of the present invention, the gasbag is applied in an immersion heat dissipation system to achieve a purpose of controlling pressure. The gasbag may adopt a gasbag that is commonly used in a municipal pipeline and a hydraulic system currently.

In essence, the gasbag can pack a gas, and part or all of surfaces of the gasbag can change according to a change of a difference between internal and external pressures, so that the gas in the gasbag can be compressed when the non-conductive working medium expands, and on the contrary, the gas in the gasbag can be expanded under the internal pressure when the volume of the non-conductive working medium is reduced. Referring to FIG. 2, FIG. 2 is a schematic diagram of a gasbag with only one movable surface 201. When a volume of the gas expands, the movable surface moves outward to increase the volume of the gas; and when the volume of the gas needs to be reduced, the movable surface moves inward to reduce the volume of the gas. In FIG. 2, (a) shows an initial state of the gasbag, (b) shows a gasbag state after the gas expands, and (c) shows a gasbag state after the gas is compressed.

If the gas in the gasbag is considered as an ideal gas in terms of engineering thermodynamics, the pressure of the gas in the gasbag complies with an ideal gas state equation in terms of engineering thermodynamics, as shown in formula (1):

$$VP = nRT \qquad\qquad (1)$$

where p represents the pressure of the gas, V represents the volume of the gas, T represents an absolute temperature of the gas, n represents the amount of substance of the ideal gas, and R represents a gas constant.

When the system works, after the non-conductive working medium absorbs heat generated by a heat source, a temperature of the non-conductive working medium increases and a volume of the non-conductive working medium expands, and the non-conductive working medium extrudes the gasbag. After the gasbag is compressed by the non-conductive working medium, due to compressibility of the gas, the gasbag reduces its volume, and meanwhile its internal pressure rises. When a balance is achieved, a decrease in volume of the gasbag is equal to an increase in volume of the non-conductive working medium after expansion. When the heat source generates less heat due to reduction of power consumption, causing that the temperature of the non-conductive working medium decreases, or when the temperature of the non-conductive working medium decreases and the volume of the non-conductive working medium is reduced due to other environmental factors, the volume of the gasbag increases and meanwhile the pressure in the gasbag decreases. When a balance is achieved, an increase in volume of the gasbag is equal to a decrease in volume of the non-conductive working medium.

That the gasbag reduces its volume when the gasbag is compressed by volume expansion of the non-conductive working medium includes: reducing, by the gasbag, its volume according to an ideal gas state equation, and calculating a reduced volume of the gasbag according to the following formula (2):

$$V_2 - V_1 = nR \left( \frac{T_2}{P_2} - \frac{T_1}{P_1} \right) \qquad\qquad (2)$$

where $V_1$ represents a volume of the gasbag before the volume of the gasbag is reduced, and $V_2$ represents a volume of the gasbag after the volume of the gasbag is reduced; $T_1$ represents an absolute temperature of the gas in the gasbag before the volume of the gasbag is reduced, and $T_2$ represents an absolute temperature of the gas in the gasbag after the volume of the gasbag is reduced; $P_1$ represents a pressure of the gas in the gasbag before the volume of the gasbag is reduced, and $P_2$ represents a pressure of the gas in the gasbag after the volume of the gasbag is reduced; n represents the amount of substance of the gas in the gasbag; and R represents a gas constant.

In this embodiment of the present invention, a working temperature of the non-conductive working medium in the immersion system is controlled within a certain range, that is, a temperature change of the gasbag falls within a certain range. If a volume $V_2$ after the volume of the gasbag is reduced or expanded and an initial volume $V_1$ of the gasbag are controlled within a certain range, the pressure in the gasbag is also controlled within a certain allowed range. Because a certain balance relationship exists between the pressure in the gasbag and the pressure of the non-conductive working medium in the immersion system, the pressure of the immersion system may be controlled through design of the gasbag.

The number of the one or more gasbags is determined according to a volume expansion value of the non-conductive working medium and a volume decrease value of each gasbag, which specifically includes calculating the number of the one or more gasbags according to formula (3):

$$\sum_{i} \nabla v_i \geq \nabla V \tag{3}$$

where $\nabla V$ represents the volume expansion value of the non-conductive working medium, and $\nabla v_i$ represents a volume decrease value of an $i^{th}$ gasbag. The number i of the gasbags needs to ensure that a sum of volume decrease values of all gasbags is greater than or equal to the volume expansion value of the non-conductive working medium.

The pressure of the immersion system can be controlled as long as a proper ratio of a total volume of the gasbags to an expansion volume of the non-conductive working medium is ensured. In this embodiment of the present invention, the shape and the number of gasbags may be flexibly set according to a specific condition in the case.

The gasbag adopted in this embodiment is a gasbag in a conventional industrial system, but in fact, the specific form of the gasbag may be varied and designed according to a specific condition of an immersion heat dissipation solution.

The gasbag is fixed at a position that is isolated from the electronic device 101 through the non-conductive working medium. By properly setting the position of the gasbag, such a design can avoid defects in an existing solution, such as defects that the electronic device is exposed in the gas and the air isolates heat exchange between the non-conductive working medium and the case, thereby further improving heat dissipation performance of the entire system.

In this embodiment of the present invention, the non-conductive working medium is a non-conductive liquid or non-conductive gas.

An embodiment of the present invention provides an immersion cooling method. Referring to FIG. 3, FIG. 3 is a flowchart of an immersion cooling method according to an embodiment of the present invention. The method includes:

S301: Dissipate heat for an electronic device by using a non-conductive working medium.

S303: A gasbag reduces its volume when the gasbag is compressed by volume expansion of the non-conductive working medium, so as to buffer a pressure rise in a system, where the pressure rise is caused by the volume expansion of the non-conductive working medium.

The system includes the electronic device, the non-conductive working medium, and one or more gasbags.

That a gasbag reduces its volume when the gasbag is compressed by volume expansion of the non-conductive working medium includes: calculating a reduced volume of the gasbag according to formula (4):

$$V_2 - V_1 = nR \left( \frac{T_2}{P_2} - \frac{T_1}{P_1} \right) \tag{4}$$

where $V_1$ represents a volume of the gasbag before the volume of the gasbag is reduced, and $V_2$ represents a volume of the gasbag after the volume of the gasbag is reduced; $T_1$ represents an absolute temperature of a gas in the gasbag before the volume of the gasbag is reduced, and $T_2$ represents an absolute temperature of the gas in the gasbag after the volume of the gasbag is reduced; $P_2$ represents a pressure of the gas in the gasbag before the volume of the gasbag is reduced, and $P_2$ represents a pressure of the gas in the gasbag after the volume of the gasbag is reduced; n represents the amount of substance of the gas in the gasbag; and R represents a gas constant.

The number of the one or more gasbags is determined according to a volume expansion value of the non-conductive working medium and a volume decrease value of each gasbag.

That the number of the one or more gasbags is determined according to the volume expansion value of the non-conductive working medium and the volume decrease value of each gasbag specifically includes determining the number of the one or more gasbags according to formula (5):

$$\sum_{i} \nabla v_i \geq \nabla V \tag{5}$$

where $\nabla V$ represents the volume expansion value of the non-conductive working medium, and $\nabla v_i$ represents a volume decrease value of an $i^{th}$ gasbag, where i is a natural number that is greater than or equal to 1 but less than or equal to N. The number i of the gasbags needs to ensure that a sum of volume decrease values of all gasbags is greater than or equal to the volume expansion value of the non-conductive working medium.

Persons skilled in the art may understand that an accompanying drawing is only a schematic diagram of an exemplary embodiment, and modules or procedures in the accompanying drawing are not necessarily required for implementing the present invention.

Finally, it should be noted that the foregoing embodiments are only intended for describing the technical solutions of the present invention rather than limiting the present invention. Although the present invention is described in detail with reference to the foregoing embodiments, persons of ordinary skill in the art should understand that they may still make modifications to the technical solutions described in the foregoing embodiments or make equivalent replacements to some technical features of the technical solutions, as long as these modifications or replacements do not make the essence of corresponding technical solutions depart from the scope of the technical solutions in the embodiments of the present invention.

**Claims**

1. An immersion cooling system, wherein:

   the system comprises an electronic device (101), a non-conductive working medium (103), and plural gasbags (105) in closed container;
   the electronic device is immersed in the non-conductive working medium;
   the non-conductive working medium is configured to dissipate heat for the electronic device, and a volume of the non-conductive working medium expands as a temperature rises; and
   a surface of the gasbag is elastic, and the gasbag is configured to reduce its volume when the gasbag is compressed by volume expansion of the non-conductive working medium, so as to buffer a pressure rise in the system, wherein the pressure rise is caused by the volume expansion of the non-conductive working medium, wherein:

   the number of gasbags is determined according to a volume expansion value of the non-conductive working medium and a volume decrease value of each gasbag, and wherein the number of gasbags is determined according to the following formula:

$$\sum_{i>1}^{N} \nabla v_i \geq \nabla V$$

   wherein $\nabla V$ represents the volume expansion value of the non-conductive working medium, and $\nabla v_i$ represents a volume decrease value of an $i^{th}$ gasbag, wherein i is a natural number that is greater than 1 less than or equal to N; and N is the number of the gasbags, and N needs to ensure that a sum of volume decrease values of all gasbags is greater than or equal to the volume expansion value of the non-conductive working medium.

2. The system according to claim 1, wherein a reduced volume of the gasbags (105) is calculated according to the following formula:

$$V_2 - V_1 = nR \left( \frac{T_2}{P_2} - \frac{T_1}{P_1} \right),$$

   wherein $V_1$ represents a volume of the gasbag before the volume of the gasbags is reduced, and $V_2$ represents a volume of the gasbags after the volume of the gasbag is reduced; $T_1$ represents an absolute temperature of a gas in the gasbags before the volume of the gasbags is reduced, and $T_2$ represents an absolute temperature of the gas in the gasbags after the volume of the gasbags is reduced; $P_2$ represents a pressure of the gas in the gasbags before the volume of the gasbags is reduced, and $P_2$ represents a pressure of the gas in the gasbags after the volume of the gasbags is reduced; n represents the amount of substance of the gas in the gasbags; and R represents a gas constant.

3. The system according to claim 1 or 2, wherein:

each gasbag (105) is fixed at a position that is isolated from the electronic device (101) through the non-conductive working medium (103).

4. The system according to claim 1, wherein:

   the non-conductive working medium (103) is a non-conductive liquid or non-conductive gas.

5. An immersion cooling method, wherein the method comprises:

   dissipating heat for an electronic device (101) by using a non-conductive working medium (103) in a closed container, wherein the electronic device is immersed in the non-conductive working medium, and placing plural gasbags (105) in the non-conductive working medium; and
   reducing, by the gasbags, their volume when the gasbags are compressed by volume expansion of the non-conductive working medium, so as to buffer a pressure rise in a system, wherein the volume expansion of the non-conductive working medium is caused by dissipating heat for the electronic device and the pressure rise is caused by the volume expansion of the non-conductive working medium wherein:

   the placing gasbags in the non-conductive working medium comprises: determining the number of gasbags according to a volume expansion value of the non-conductive working medium and a volume decrease value of each gasbag, and wherein:

   the determining the number of the gasbags according to a volume expansion value of the non-conductive working medium and a volume decrease value of each gasbag specifically comprises: determining the number of gasbags according to the following formula:

$$\sum_{i>1}^{N} \nabla v_i \geq \nabla V$$

   wherein $\nabla V$ represents the volume expansion value of the non-conductive working medium, and $\nabla v_i$ represents a volume decrease value of an $i^{th}$ gasbag, wherein i is a natural number that is greater than 1 but less than or equal to N; and N is the number of the gasbags, and N needs to ensure that a sum of volume decrease values of all gasbags is greater than or equal to the volume expansion value of the non-conductive working medium.

6. The method according to claim 5, wherein a reduced volume of the gasbags (105) is determined according to the following formula:

$$V_2 - V_1 = nR \left( \frac{T_2}{P_2} - \frac{T_1}{P_1} \right),$$

   wherein $V_1$ represents a volume of the gasbags before the volume of the gasbags is reduced, and $V_2$ represents a volume of the gasbags after the volume of the gasbags is reduced, $T_1$ represents an absolute temperature of a gas in the gasbags before the volume of the gasbags is reduced, and $T_2$ represents an absolute temperature of the gas in the gasbags after the volume of the gasbags is reduced; $P_1$ represents a pressure of the gas in the gasbags before the volume of the gasbags is reduced, and $P_2$ represents a pressure of the gas in the gasbags after the volume of the gasbags is reduced; n represents the amount of substance of the gas in the gasbags; and R represents a gas constant.

7. The method according to claim 5, wherein:

   the non-conductive working medium (103) is a non-conductive liquid or non-conductive gas.

**Patentansprüche**

1. Immersionskühlsystem, wobei:

das System eine elektronische Vorrichtung (101), ein nicht leitfähiges Arbeitsmedium (103) und mehrere Gasbeutel (105) in einem geschlossenen Behälter umfasst;

die elektronische Vorrichtung in das nicht leitfähige Arbeitsmedium eingetaucht ist;

das nicht leitfähige Arbeitsmedium dafür ausgelegt ist, Wärme für die elektronische Vorrichtung abzuführen, und ein Volumen des nicht leitfähigen Arbeitsmediums sich ausdehnt, wenn die Temperatur ansteigt; und eine Oberfläche des Gasbeutels elastisch ist, und der Gasbeutel dafür ausgelegt ist, sein Volumen zu reduzieren, wenn der Gasbeutel durch Volumenexpansion des nicht leitfähigen Arbeitsmediums komprimiert wird, um so einen Druckanstieg im System abzupuffern, wobei der Druckanstieg durch die Volumenexpansion des nicht leitfähigen Arbeitsmediums verursacht wird, wobei:

die Anzahl der Gasbeutel gemäß einem Volumenexpansionswert des nicht leitfähigen Arbeitsmediums und einem Volumenverringerungswert jedes Gasbeutels bestimmt wird, und wobei die Anzahl der Gasbeutel gemäß der folgenden Formel bestimmt wird:

$$\sum_{i>1}^{N} \nabla_{v_i} \geq \nabla V$$

wobei $\nabla_V$ den Volumenexpansionswert des nicht leitfähigen Arbeitsmediums repräsentiert, und $\nabla_{v_i}$ einen Volumenverringerungswert eines i-ten Gasbeutels repräsentiert, wobei i eine natürliche Zahl ist, die größer als 1, aber kleiner oder gleich N ist; und N die Zahl der Gasbeutel ist, und N sicherstellen muss, dass eine Summe von Volumenverringerungswerten aller Gasbeutel größer oder gleich dem Volumenexpansionswert des nicht leitfähigen Arbeitsmediums ist.

2. System nach Anspruch 1, wobei ein reduziertes Volumen der Gasbeutel (105) gemäß der folgenden Formel berechnet wird:

$$V_2 - V_1 = nR\left(\frac{T_2}{P_2} - \frac{T_1}{P_1}\right)$$

wobei $V_1$ ein Volumen des Gasbeutels repräsentiert, bevor das Volumen der Gasbeutel reduziert wird, und $V_2$ ein Volumen der Gasbeutel repräsentiert, nachdem das Volumen des Gasbeutels reduziert ist; $T_1$ eine absolute Temperatur eines Gases in den Gasbeuteln, bevor das Volumen der Gasbeutel reduziert wird, repräsentiert und $T_2$ eine absolute Temperatur des Gases in den Gasbeuteln, nachdem das Volumen der Gasbeutel reduziert ist, repräsentiert; $P_2$ einen Druck des Gases in den Gasbeuteln, bevor das Volumen der Gasbeutel reduziert wird, repräsentiert und $P_2$ einen Druck des Gases in den Gasbeuteln, nachdem das Volumen der Gasbeutel reduziert wurde, repräsentiert; n die Menge an Substanz von Gas in den Gasbeuteln repräsentiert; und R eine Gaskonstante darstellt.

3. System nach Anspruch 1 oder 2, wobei:

jeder Gasbeutel (105) an einer Position befestigt ist, die von der elektronischen Vorrichtung (101) durch das nicht leitfähige Arbeitsmedium (103) isoliert ist.

4. System nach Anspruch 1, wobei:

das nicht leitfähige Arbeitsmedium (103) eine nicht leitfähige Flüssigkeit oder ein nicht leitfähiges Gas ist.

5. Immersionskühlverfahren, wobei das Verfahren umfasst:

Ableiten von Wärme für eine elektronische Vorrichtung (101) durch Verwendung eines nicht leitfähigen Arbeitsmediums (103) in einem geschlossenen Behälter, wobei die elektronische Vorrichtung in das nicht leitfähige Arbeitsmedium eingetaucht ist, und Platzieren von mehreren Gasbeuteln (105) im nicht leitfähigen Arbeitsmedium; und durch die Gasbeutel, Reduzieren ihres Volumens, wenn die Gasbeutel durch Volumenexpansion des nicht leitfähigen Arbeitsmediums komprimiert werden, um so einen Druckanstieg in einem System abzupuffern, wobei die Volumenexpansion des nicht leitfähigen Arbeitsmediums durch Ableiten von Wärme für die elektronische Vorrichtung verursacht wird und der Druckanstieg durch die Volumenexpansion des nicht leitfähigen Arbeitsmediums verursacht wird, wobei:

das Platzieren der Gasbeutel im nicht leitfähigen Arbeitsmedium umfasst: Bestimmen der Anzahl der Gasbeutel gemäß einem Volumenexpansionswert des nicht leitfähigen Arbeitsmediums und einem Volumenverringerungswert jedes Gasbeutels, und wobei:

das Bestimmen der Anzahl der Gasbeutel gemäß einem Volumenexpansionswert des nicht leitfähigen Arbeitsmediums und einem Volumenverringerungswert jedes Gasbeutels spezifisch umfasst: Bestimmen der Anzahl der Gasbeutel gemäß der folgenden Formel:

$$\sum_{i>1}^{N} \nabla_{v_i} \geq \nabla V$$

wobei $\nabla_V$ den Volumenexpansionswert des nicht leitfähigen Arbeitsmediums repräsentiert, und $\nabla_{v_i}$ einen Volumenverringerungswert eines i-ten Gasbeutels repräsentiert, wobei i eine natürliche Zahl ist, die größer als 1 ist, aber kleiner oder gleich N ist; und N die Zahl der Gasbeutel ist und N sicherstellen muss, dass eine Summe von Volumenverringerungswerten aller Gasbeutel größer oder gleich dem Volumenexpansionswert des nicht leitfähigen Arbeitsmediums ist.

6. Verfahren nach Anspruch 5, wobei ein reduziertes Volumen der Gasbeutel (105) gemäß der folgenden Formel berechnet wird:

$$V_2 - V_1 = nR\left(\frac{T_2}{P_2} - \frac{T_1}{P_1}\right)$$

wobei $V_1$ ein Volumen der Gasbeutel repräsentiert, bevor das Volumen der Gasbeutel reduziert wird, und $V_2$ ein Volumen der Gasbeutel repräsentiert, nachdem das Volumen der Gasbeutel reduziert ist; $T_1$ eine absolute Temperatur eines Gases in den Gasbeuteln, bevor das Volumen der Gasbeutel reduziert wird, repräsentiert und $T_2$ eine absolute Temperatur des Gases in den Gasbeuteln, nachdem das Volumen der Gasbeutel reduziert wurde, repräsentiert; $P_1$ einen Druck des Gases in den Gasbeuteln, bevor das Volumen der Gasbeutel reduziert wird, repräsentiert und $P_2$ einen Druck des Gases in den Gasbeuteln, nachdem das Volumen der Gasbeutel reduziert wurde, repräsentiert; n die Menge an Substanz von Gas in den Gasbeuteln repräsentiert; und R eine Gaskonstante darstellt.

7. Verfahren nach Anspruch 5, wobei:

das nicht leitfähige Arbeitsmedium (103) eine nicht leitfähige Flüssigkeit oder ein nicht leitfähiges Gas ist.

**Revendications**

1. Système de refroidissement par immersion, dans lequel :

le système comprend un dispositif électronique (101), un milieu de travail non conducteur (103) et une pluralité de ballonnets à gaz (105) dans un récipient fermé ;
le dispositif électronique est immergé dans le milieu de travail non conducteur ;
le milieu de travail non conducteur est configuré pour dissiper la chaleur pour le dispositif électronique, et un volume du milieu de travail non conducteur se dilate lorsqu'une température augmente ; et
une surface du ballonnet à gaz est élastique, et le ballonnet à gaz est configuré pour réduire son volume quand le ballonnet à gaz est comprimé par la dilatation volumique du milieu de travail non conducteur, de manière à absorber une augmentation de pression dans le système, l'augmentation de pression étant provoquée par la dilatation volumique du milieu de travail non conducteur, dans lequel :

le nombre de ballonnets à gaz est déterminé en fonction d'une valeur de dilatation volumique du milieu de travail non conducteur et d'une valeur de diminution de volume de chaque ballonnet à gaz, et dans lequel le nombre de ballonnets à gaz est déterminé selon la formule suivante :

$$\sum_{i>1}^{N} \nabla v_i \ \geq \ \nabla V$$

dans laquelle $\nabla V$ représente la valeur de dilatation volumique du milieu de travail non conducteur, et $\nabla v_i$ représente une valeur de diminution de volume d'un i-ième ballonnet à gaz, i étant un entier naturel qui est supérieur à 1, mais inférieur ou égal à N ; et N est le nombre des ballonnets à gaz, et N doit garantir qu'une somme de valeurs de diminution de volume de tous les ballonnets à gaz est supérieure ou égale à la valeur de dilatation volumique du milieu de travail non conducteur.

**2.** Système selon la revendication 1, dans lequel un volume réduit des ballonnets à gaz (105) est calculé selon la formule suivante :

$$V_2 - \ V_1 = nR \ \left(\frac{T_2}{P_2} - \frac{T_1}{P_1}\right),$$

dans laquelle $V_1$ représente un volume des ballonnets à gaz avant que le volume des ballonnets à gaz soit réduit, et $V_2$ représente un volume des ballonnets à gaz après que le volume des ballonnets à gaz a été réduit ; $T_1$ représente une température absolue d'un gaz dans les ballonnets à gaz avant que le volume des ballonnets à gaz soit réduit, et $T_2$ représente une température absolue du gaz dans les ballonnets à gaz après que le volume des ballonnets à gaz a été réduit ; $P_2$ représente une pression du gaz dans les ballonnets à gaz avant que le volume des ballonnets à gaz soit réduit, et $P_2$ représente une pression du gaz dans les ballonnets à gaz après que le volume des ballonnets à gaz a été réduit ; n représente la quantité de substance du gaz dans les ballonnets à gaz ; et R représente une constante des gaz.

**3.** Système selon la revendication 1 ou 2, dans lequel :

chaque ballonnet à gaz (105) est fixé à une position qui est isolée du dispositif électronique (101) par le milieu de travail non conducteur (103).

**4.** Système selon la revendication 1, dans lequel :

le milieu de travail non conducteur (103) est un liquide non conducteur ou un gaz non conducteur.

**5.** Procédé de refroidissement par immersion, le procédé comprenant :

la dissipation de la chaleur pour un dispositif électronique (101) au moyen d'un milieu de travail non conducteur (103) dans un récipient fermé, le dispositif électronique étant immergé dans le milieu de travail non conducteur, et le positionnement d'une pluralité de ballonnets à gaz (105) dans le milieu de travail non conducteur ; et la réduction, par les ballonnets à gaz, de leur volume quand les ballonnets à gaz sont comprimés par la dilatation volumique du milieu de travail non conducteur, de manière à absorber une augmentation de pression dans un système, la dilatation volumique du milieu de travail non conducteur étant provoquée par la dissipation de la chaleur pour le dispositif électronique et l'augmentation de pression étant provoquée par la dilatation volumique du milieu de travail non conducteur, dans lequel :

le positionnement de ballonnets à gaz dans le milieu de travail non conducteur comprend : la détermination du nombre de ballonnets à gaz en fonction d'une valeur de dilatation volumique du milieu de travail non conducteur et d'une valeur de diminution de volume de chaque ballonnet à gaz, et dans lequel :

la détermination du nombre des ballonnets à gaz en fonction d'une valeur de dilatation volumique du milieu de travail non conducteur et d'une valeur de diminution de volume de chaque ballonnet à gaz comprend spécifiquement : la détermination du nombre de ballonnets à gaz selon la formule suivante :

$$\sum_{i>1}^{N} \nabla v_i \ \geq \ \nabla V$$

dans laquelle $\nabla V$ représente la valeur de dilatation volumique du milieu de travail non conducteur, et $\nabla v_i$ représente une valeur de diminution de volume d'un i-ième ballonnet à gaz, i étant un entier naturel qui est supérieur à 1, mais inférieur ou égal à N ; et N est le nombre des ballonnets à gaz, et N doit garantir qu'une somme de valeurs de diminution de volume de tous les ballonnets à gaz est supérieure ou égale à la valeur de dilatation volumique du milieu de travail non conducteur.

6.  Procédé selon la revendication 5, dans lequel un volume réduit des ballonnets à gaz (105) est calculé selon la formule suivante :

$$V_2 - V_1 = nR \left( \frac{T_2}{P_2} - \frac{T_1}{P_1} \right),$$

dans laquelle $V_1$ représente un volume des ballonnets à gaz avant que le volume des ballonnets à gaz soit réduit, et $V_2$ représente un volume des ballonnets à gaz après que le volume des ballonnets à gaz a été réduit ; $T_1$ représente une température absolue d'un gaz dans les ballonnets à gaz avant que le volume des ballonnets à gaz soit réduit, et $T_2$ représente une température absolue du gaz dans les ballonnets à gaz après que le volume des ballonnets à gaz a été réduit ; $P_1$ représente une pression du gaz dans les ballonnets à gaz avant que le volume des ballonnets à gaz soit réduit, et $P_2$ représente une pression du gaz dans les ballonnets à gaz après que le volume des ballonnets à gaz a été réduit ; n représente la quantité de substance du gaz dans les ballonnets à gaz ; et R représente une constante des gaz.

7.  Procédé selon la revendication 5, dans lequel :

le milieu de travail non conducteur (103) est un liquide non conducteur ou un gaz non conducteur.

FIG. 1

FIG. 2

FIG. 3

**EP 2 665 349 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5373417 A